## Europäisches Patentamt
## European Patent Office
## Office européen des brevets

(11) Publication number: **0 146 479**
A2

# EUROPEAN PATENT APPLICATION

(21) Application number: **84402667.4**

(22) Date of filing: **20.12.84**

(51) Int. Cl.⁴: **H 03 K 17/04**

(30) Priority: **20.12.83 US 563568**

(43) Date of publication of application: **26.06.85**
**Bulletin 85/26**

(84) Designated Contracting States: **DE FR GB IT NL**

(71) Applicant: **FAIRCHILD CAMERA & INSTRUMENT CORPORATION, 464 Ellis Street, Mountain View California 94042 (US)**

(72) Inventor: **Dvorak, Robert V., 23 Jane Drive, Scotia New York 12302 (US)**

(74) Representative: **Chareyron, Lucien et al, Schlumberger Limited Service Brevets c/o Giers 12, place des Etats Unis B.P. 121, F-92124 Montrouge Cédex (FR)**

(54) Method and apparatus for reducing the storage time in a saturated transistor.

(57) The storage time of a saturated transistor is reduced by connecting a low impedance current source or sink to the base of the transistor in response to a control pulse which turns the transistor off, to thereby increase the rate at which the excess minority carriers are removed from the base. The connection of the current source or sink to the base is provided by means of an inductor connected to the base terminal of the transistor and an auxiliary transistor that is actuated in response to the voltage across the inductor. A change of the current through the inductor produces a voltage transient across the inductor, which is applied to the base of the auxiliary transistor to turn it on. In turn, the auxiliary transistor connects the base of the main switching transistor to a current source or sink, depending on the type of transistor, to thereby increase the current flow into or out of the base region of the transistor, thus reducing its storage time.

-1-

## METHOD AND APPARATUS FOR REDUCING THE STORAGE TIME IN A SATURATED TRANSISTOR

### Background of the Invention

#### Field of the Invention

The present invention is directed to transistor switching circuits, and more particularly to a circuit for reducing the storage time in a saturated bipolar transistor and thereby decreasing the length of time that it takes the transistor to switch from a conductive to a non-conductive state in response to a control pulse.

Automatic test system circuits for stimulating electronic assemblies, known as pin drivers, typically comprise a pair of complementary bipolar transistors with their output terminals, e.g., collectors, wired together. These transistors are alternately actuated to selectively connect a test pin to a current source or a current sink. Due to the nature of the pin driver circuit design, one of the transistors must be completely turned off before the other one is turned on, or else a short circuit condition between the current source and sink will result. Typically, the turn-on time for a transistor is much shorter than its turn-off time. Consequently, to maintain the above condition in which only one transistor is turned on at any given time, delays are built into the stages of the pin driver circuit so that one transistor will not turn on before the other turns off in response to a given input pulse.

It will be appreciated that the introduction of such delays into the pin driver circuit limits the maximum speed at which the switching transistors can be turned on and off. Consequently, the test frequency of the testing assembly is likewise limited. Accordingly, it is desirable to reduce the time it takes a transistor to turn off so that such time is more equal in length to the turn-on time.

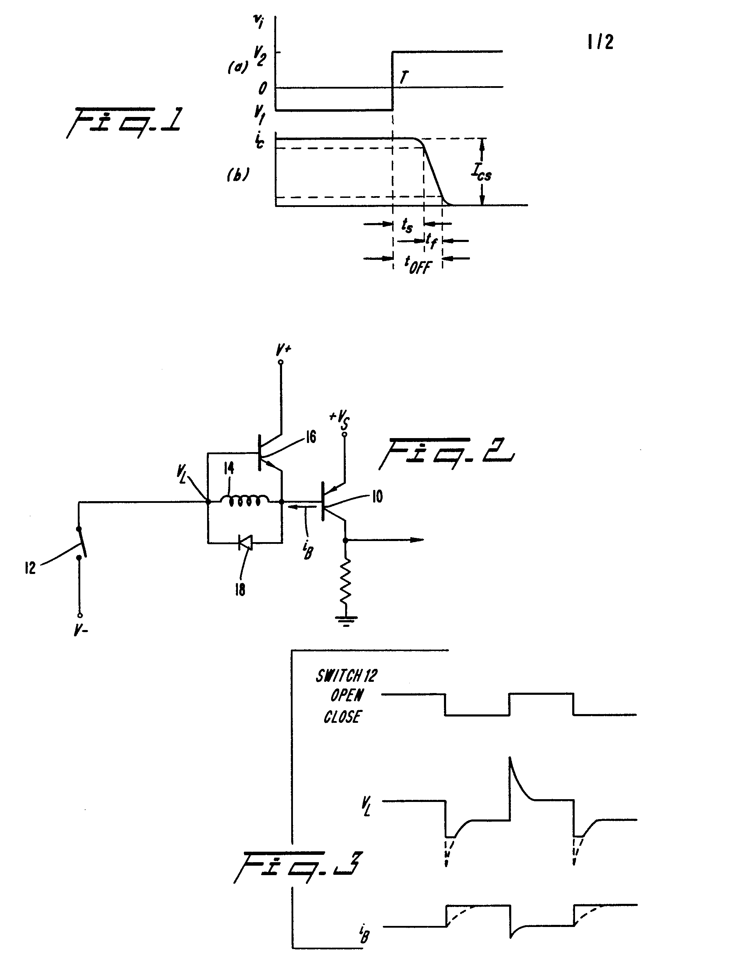

The time it takes a transistor to turn off in response to a control pulse is the sum of two of its characteristics, i.e. its storage time and its fall time. These characteristic times of a transistor are illustrated in Figure 1 for the case of a p-n-p transistor. The input waveform $v_i$ measured between the base and emitter terminals of the transistor is comprised of two states respectively defined by two voltage levels $V_1$ and $V_2$. When this input signal is at level $V_1$, the transistor is in the saturated state, and at $V_2$ the transistor is at cut-off. As illustrated in Figure 1(b), when the input signal is at the $V_1$ level, the collector current $i_C$ of the transistor is at its maximum saturation value $I_{CS}$.

A control pulse to turn the transistor off is formed at time T when the input signal $v_i$ rises from level $V_1$ to level $V_2$. The transistor does not immediately respond to the leading edge of this pulse. Rather, because the transistor was in the saturated state, it has a saturation charge of excess minority carriers stored in its base region. This excess charge must be removed before the transistor can begin to turn off. The time that is required to remove these minority carriers, typically defined as the time it takes the collector current $i_C$ for the transistor to drop to 90% of the saturation value $I_{CS}$ following the leading edge of the control pulse, is known as the storage time $t_s$. This interval is followed by the transistor's fall time $t_f$ which is the time that it

-3-

takes for the collector current to fall from 90% to 10% of the saturation value. The total turnoff time $t_{OFF}$ for the transistor is the sum of the storage and fall times. Of these two times that contribute to the total turnoff time for the transistor, the storage time is the more significant in terms of relative lengths, and hence is the subject of the present invention.

Description of the Prior Art

In the past, one approach which has been taken to overcome the effects of transistor storage time, and thereby increase the switching speed of a transistor, has been to prevent the transistor from going into saturation by removing excess base current. Two popular circuits for achieving this function are the Schottky clamp, in which a Schottky diode is connected between the base and collector terminals of the transistor, and the Baker clamp which utilizes a pair of diodes having one terminal connected in common and the other terminals being respectively connected to the base and collector of the transistor. While these circuits are successful in reducing the switching time of the transistor, they are not without their inherent limitations. For example, the Schottky diode exhibits low $V_f$ (forward voltage) only at low currents. If the current level through the transistor is very high, for example up to 500 mA that might be encountered in a test pin, the $V_f$ of the diode is too high to properly clamp the base signal. Another drawback is that both types of clamps result in a larger collector-emitter voltage than may be desired in many applications. Furthermore, the diodes of these clamps function as feedback elements and can become unstable unless they are slowed down, which defeats the purpose for which they are being utilized.

0146479

-4-

In addition, it may be desirable in certain applications to have the transistor go fully into saturation, in which case these clamping circuits can not be utilized.

In another approach to improving the shut-off characteristics of a transistor, a shunt resistor is connected to the base of the transistor to apply a reverse current to the base when the transistor driving signal is removed. A problem associated with this approach, however, is that it consumes power during times other than when the transistor is being turned off. As the current that is applied through the resistor is increased to turn the transistor off faster, the amount of power that is wasted is also increased.

Accordingly, it is a general object of the present invention to provide an improved circuit for reducing the storage time in a saturated transistor to thereby decrease the time it takes the transistor to switch from fully on to fully off states.

## Brief Statement of the Invention

In accordance with the present invention, these and other objects are achieved by connecting a low impedance current source or sink to the base of the transistor in response to a control pulse which turns the transistor off, to thereby increase the rate at which the excess minority carriers are removed from the base, thus effectively reducing the storage time of the transistor. The connection of the current source or sink to the base is provided by means of an inductor connected to the base terminal of the transistor and an auxiliary transistor that is actuated in response to the voltage across the inductor. The edge of a control pulse results in a change of the current through the inductor, which produces a voltage transient across the inductor. This voltage is applied to the base of the auxiliary transistor to turn it on. When this happens, the auxiliary transistor connects the base of the main switching transistor to a current source or sink, depending on the type of transistor, to thereby increase the current flow and hence the transfer of stored minority carriers out of the base region of the transistor, thus reducing its storage time.

Further features and advantages of the invention are described in greater detail with particular reference to preferred embodiments of the invention illustrated in the accompanying drawings.

### Brief Description of the Drawings

Figure 1 is a voltage/timing diagram illustrating the typical turnoff characteristics of a transistor;

Figure 2 is a schematic circuit diagram of a switching circuit incorporating the reduced storage time concept of the present invention;

Figure 3 is a voltage/timing diagram illustrating characteristics of the operation of the circuit of Figure 2;

Figure 4 is a schematic electrical diagram of a pin-driving circuit incorporating the principles of the present invention; and

Figure 5 is a schematic circuit diagram of a second embodiment of the invention.

## Description of the Illustrated Embodiments

In the following description of preferred embodiments of the present invention, particular reference is made to use of the invention in a pin driver circuit for automatic test equipment, in order to facilitate an understanding of the invention and its application. However, it will be appreciated by those having familiarity with this technology that the practical applications of the invention are not so limited. Rather, the invention can be feasibly utilized in any environment in which it is desired to be able to rapidly turn off a saturated transistor.

Referring to Figure 2, a switching circuit includes a switching transistor 10 having its emitter and collector terminals respectively connected to relatively high and low potentials. The base terminal of the transistor is connected to a low voltage source through a switch 12. In operation, when the switch 12 is closed to connect the base of the transistor 10 to the low voltage source, i.e., current sink, the transistor is rendered conducting to present a high voltage signal at its collector output terminal. When the switch 12 is opened, the transistor is turned off and a relatively low voltage signal appears at its output terminal.

In order to increase the responsiveness with which the transistor turns off in response to opening of the switch 12, a storage time reduction circuit constructed in accordance with the present invention is connected to the base of the transistor. This storage time reduction circuit includes an inductor 14 connected in series between the base terminal of the transistor and the switch 12, and an auxiliary transistor 16 of a type that is complementary to the main switching transistor 10, i.e., the main transistor 10 is a p-n-p transistor and the auxiliary transistor 16 is n-p-n. The auxiliary transistor 16 is connected so that its base-emitter circuit is in parallel with the inductor, with its emitter terminal being connected to the junction of the inductor 14 and the base of the switching transistor 10, and its base terminal being connected to the other terminal of the inductor 14, i.e., the one that is remote from the base of the switching transistor 10. The collector of the auxiliary transistor 16 is connected to a positive voltage source.

In a preferred embodiment of the invention, the auxiliary transistor 16 is a "fast" transistor as opposed to a relatively slow power transistor that is typically employed as the switching transistor 10.

In operation, each time that the switch 12 is opened and closed, the change in the flow of current through the inductor 14 results in the establishment or collapse of the inductor's magnetic field, producing a voltage transient across the inductor. The voltage appearing across the inductor is illustrated in Figure 3. When the switch 12 is opened to turn the switching transistor off, the inductor's magnetic field begins to collapse and a sharp positive voltage transient appears across the inductor. Application of this voltage to the base of the auxiliary transistor 16 renders this transistor conducting, to thereby provide a low impe-

0146479

-8-

dance current source through the collector-emitter path of the transistor 16 to the base of the switching transistor 10. In other words, the transistor 16 amplifies the energy in the inductor 14. The effect of this energy is to increase the current flow into the base of the switching transistor 10, resulting in a rapid depletion of the stored minority carriers and hence a reduction in the transistor's storage time.

Once the magnetic field of the inductor 14 has completely collapsed, the high voltage will no longer be present at the base terminal of the auxiliary transistor 16. Accordingly, this transistor will turn off. Thus, it will be appreciated that the auxiliary transistor 16 is rendered conducting, and therefore consumes power, only for a brief period of time beginning with the opening of the switch 12, to cause the main switching transistor 10 to rapidly turn off. Once this function has been accomplished, the auxiliary transistor 16 also turns off and thus minimizes power consumption. Consequently, a relatively large current can be applied to the base of the transistor 10 to turn it off rapidly without needlessly wasting a large amount of power.

Further in this regard, the inductor 14 can be chosen, in connection with the base current of the transistor 10, so that it presents a driving voltage which is only so large and lasts only so long as is necessary to maintain the transistor 16 conducting for a period of time adequate to provide a sufficient reverse current to the base of the transistor 10 to rapidly turn it off. Hence, this inductor can be quite small.

When the switch 12 is subsequently closed to render the switching transistor 10 conducting, the impedance presented by the inductor 14 can slow down the rate at which the transistor 10 turns on. In effect, the transistor will turn on slowly in accordance with a ramp function, as illustrated by the dashed line in Figure 3, rather than quickly turning on in response to the driving pulse applied as a result of the closing of the switch. In order to negate the impedance of the inductor during the actuation of the transistor 10, a diode 18 can be placed in shunt with the inductor. Thus, when the switch 12 is closed to connect the transistor to the current sink, the diode 18 allows the transistor base current to bypass the inductor, enabling the switch to rapidly turn on. In addition, the diode functions to clip the negative voltage spike which appears at the terminal of the inductor, as illustrated by the dashed and solid lines in Figure 3. However, the diode 18 has no effect upon the operation outlined above with respect to reduction in the transistor's storage time.

In the embodiment of Figure 2, the switching transistor 10 is shown as a p-n-p type transistor and the auxiliary transistor 16 is of the complementary type. It will be appreciated that the invention is equally applicable to n-p-n type switching transistors. In such a case, the auxiliarly transistor 16 would be a p-n-p type transistor whose collector is connected to a current sink, and the by-pass diode 18 would be connected in the reverse manner from that shown in Figure 2.

An example of a pin driver circuit for automatic test equipment which incorporates the storage time reduction circuit of the present invention as illustrated in Figure 4. The pin driver circuit basically comprises a pair of complementary transistors 20 and 22 whose collector terminals are wired together to form the output terminal of the circuit. The emitters of these transistors are respectively connected to a current source and a current sink. The base terminals of these resistors are respectively connected to a negative driving potential and positive driving potential through a pair of switches 24 and 26. Preferably, these switches are alternately actuated in common, as shown by the dashed line, so as to alternately turn the transistors 20 and 22 on, i.e., one transistor is turned on as the other is turned off.

A storage time reduction circuit comprising an inductor 28, an auxiliary transistor 30 and a bypass diode 32 is connected to the base of each of the switching transistors 20 and 22 in the manner described previously with respect to Figure 2. Each auxiliary transistor 30 is of a type that is complementary to the switching transistor 20 or 22 to which it is connected. Advantageously, the bias potentials that are applied to the base terminals of the respective transistors 20 and 22 through the auxiliary transistors 30 can be derived from the driving potentials that are applied through the switches 24 and 26.

With the application of the storage time reduction circuit to the switching transistors of the pin driver, there is no longer a need to insert a delay into the line connected to the base of each of the switching transistors 20 and 22 so as to insure that one transistor does not turn on before the other turns completely off. In actual tests utilized in the circuit of the type illustrated in Figure 4, switching of a drive current of about 20-25mA by means of the switches 24 and 26 results in a current pulse through the auxiliary transistors of about 28mA peak, which lasts .approximately 5-10 nS. The turn-off time of the switching transistors 20 and 22 is reduced from a normal time of about 50 nS to about 10 nS. This 80% reduction of the transistor turn-off time results in an increased throughput rate for the automatic test equipment, since a much higher testing frequency can be utilized.

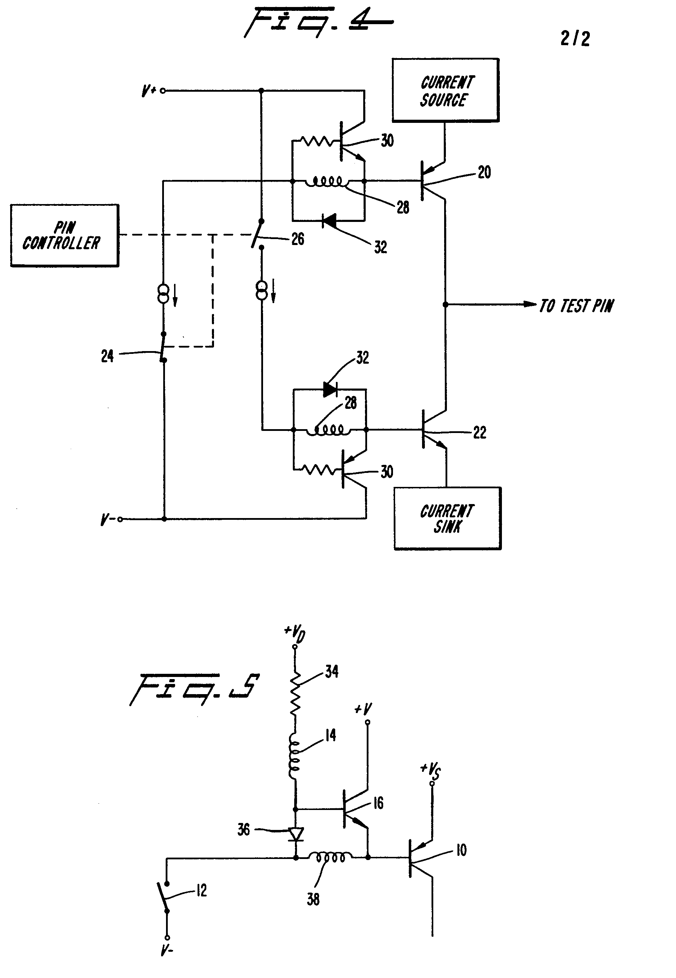

Figure 5 illustrates a second embodiment of the invention which exhibits a response time that is even faster than that available with the embodiment of Figure 2. In this embodiment, the inductor 14 which produces the actuating voltage to turn on the auxiliary transistor 16 is not connected in series with the base of the switching transistor 10. Rather, it is disposed in a shunt type of configuration. More particularly, the inductor 14 is connected between the base of the auxiliary transistor 16 and a source of potential $V_D$. A resistor 34 is connected in series with the inductor 14 to limit the current drain on the source. A diode 36 is also connected in series with the inductor 14, between the base terminals of the two transistors.

In operation, when the switch 12 is closed, a small current flows from the source $V_D$ to the current sink, through the series connection of the resistor 34, inductor 14 and diode 36. In this regard, the geometry, i.e., operating characteristics, of the diode 36 should be chosen relative to that of the transistor 16 so that the diode conducts current but the transistor 16 is not actuated when the switch is closed. When the switch 12 is subsequently opened, the flow of current through the inductor is interrupted, causing the generation of a voltage pulse as its magnetic field collapses. This pulse turns on the auxiliary transistor 16 to connect the bias potential to the base of the switching transistor 10.

When the switch 12 is opened, some current flows to the base of the transistor 10 through the diode 36 as a result of the voltage generated across the inductor 14. If this path of current flow is not desired, a second inductor 38 can be connected between the emitter of the auxiliary transistor 16 and the cathode of the diode 36. With this modification, when the switch 12 is opened, a voltage will appear across the inductor 38 in addition to the inductor 14. This voltage will reverse bias the diode 36 to turn it off. Therefore, all of the voltage across the inductor 14 is applied to the base of the transistor 16.

The two inductors 14 and 38 that are employed in this embodiment of the invention can be quite small, for example, in the neighborhood of $2.7 \mu h$ each, to thereby provide the high switching speed capability.

Although the storage time reduction circuit shown in the embodiment of Figure 5 does draw some power from the potential source $V_D$ when the switch 12 is closed, it will be appreciated that the magnitude of the current drain can be much less than that consumed in the prior art shunt resistor circuits, since the combined impedance of the resistor 34 and the induction 14 can be much larger than that of a shunt resistor alone, to thereby limit the current.

In addition to the increased speed which the latter embodiment provides, another advantage may dictate its use in particular applications. For example, if the switch 12 is a monolithic (i.e., solid state) switch, its thermal characteristics may cause the base current for the switching transistor 10 to increase over time as the switch warms up after being turned on. Since the voltage across an inductor is determined by the change in current flowing therethrough, an inductor in series with the base of the switching transistor 10 could generate sufficient voltage to unintentionally turn the auxiliary transistor 16 on. However, the current through a shunt inductor is maintained constant by the resistor 34, and thus is less susceptible to changes in the conductance of the switch 12.

It will be appreciated by those of ordinary skill in the art that the present invention can be embodied in other specific forms without departing from the spirit or essential characteristics thereof. For example, although the invention has been particularly described with respect to its application in a pin driver circuit, it can find utility in a number of applications, such as needle drivers for thermal printers, hammer drivers in line printers or any other environment in which it is desirable to switch a high current at a fast rate. Accordingly, the presently disclosed embodiments are considered in all respects to be illustrative and not restrictive. The scope of the invention is illustrated by the appended claims rather than the foregoing description, and all changes that come within the meaning and range of equivalents thereof are intended to be embraced therein.

0146479

WHAT IS CLAIMED IS:

1.    A circuit for reducing the storage time
of a saturated switching transistor, to thereby
decrease the time it takes for the transistor to turn
off in response to a control pulse, characterized by:
an inductor operatively connected to the
source of the control pulse so that current flow
through said inductor changes when said switching
transistor is actuated; and
an auxiliary transistor having its emitter
connected to the base of said switching transistor, its
base connected to said inductor, and its collector
connected to a bias potential, so that a change in
current flow through said inductor that is caused by
the edge of a control pulse produces a voltage at the
base of said auxiliary transistor to thereby render
said auxiliary transistor conducting to connect the
base of said switching transistor to said bias
potential.

2.    The circuit of claim 1 characterized in
that said switching transistor is one of the types of
n-p-n and p-n-p, and said auxilairy transistor is of
the complementary type.

3.    The circuit of claim 1 or 2 characterized
in that said inductor is connected in series between
the source of the control pulse and the base of said
switching transistor.

4.    The circuit of claim 1, 2 or 3
characterized in that the emitter of said auxiliary
transistor is connected to the junction of said
inductor and the base of said switching transistor, and the base of said auxiliary transistor is connected to the terminal of said inductor that is remote from said junction.

5. The circuit of claim 3 or 4 characterized by a diode connected in parallel with said inductor to shunt the impedance of said inductor when said switching transistor is turned on by a control pulse.

6. The circuit of claim 1 or 2 characterized in that said inductor is connected in series between the source of the control pulse and a second potential.

7. The circuit of claim 6 characterized by a resistor in series with said inductor.

8. The circuit of claim 6 or 7 characterized by a diode connected between the base of said auxiliary transistor and the source of the control pulse.

9. The circuit of claim 8 characterized by a second inductor connected between the emitter of said auxiliary transistor and said diode.

10. The switching circuit of any one of claims 2-9 for use as a pin driver circuit for automatic test equipment characterized in that:
said switching transistor has one of its emitter and collector connected to a current source; and by
a second switching transistor of a type complementary to said first switching transistor, having said one of its emitter and collector connected to a current sink, the other of the emitters and collectors of said switching transistors being connected to one another and forming the output terminal of said circuit;

a second inductor operatively connected to the source of control pulse so that current flow through said inductor changes when said second switching transistor is actuated;

a second auxiliary transistor of a type complementary to said second switching transistor having its base connected to the inductor associated with said second switching transistor, its emitter connected to the base of said second switching transistor and its collector connected to a second bias potential;

said control pulses being generated by means alternately connecting the base of one of said switching transistors to a relatively low driving potential and connecting the base of the other of said switching transistors to a relatively high driving potential so as to alternately turn said switching transistors on.

11. The pin driver circuit of claim 10 characterized in that said low driving potential is the same as one of said bias potentials and said high driving potential is the same as the other of said bias potentials.

12. A method for reducing the storage time of a saturated transistor, characterized by the steps of:

generating a voltage pulse in response to a signal indicating that the transistor is to be turned off; and

connecting one of a current source and a current sink to the base of said transistor in response to said voltage pulse to thereby rapidly deplete the minority carriers stored in the base region of the transistor.

0146479

13. The method of claim 12 characterized by the step of limiting voltage pulses that can be produced when a driving current is applied to the base of the transistor to turn said transistor on.

Fig.1

(a)

(b)

Fig.2

Fig.3

Fig.4

Fig.5